**Europäisches Patentamt**

**European Patent Office**

**Office européen des brevets**

(19)

(11) Veröffentlichungsnummer: **0 168 654**
**B1**

(12) **EUROPÄISCHE PATENTSCHRIFT**

(45) Veröffentlichungstag der Patentschrift:
21.06.89

(51) Int. Cl.⁴: **H 03 K 4/50**

(21) Anmeldenummer: **85107478.1**

(22) Anmeldetag: **15.06.85**

(54) Sägezahngenerator.

(30) Priorität: **14.07.84 DE 3426061**

(43) Veröffentlichungstag der Anmeldung:
**22.01.86 Patentblatt 86/4**

(45) Bekanntmachung des Hinweises auf die Patenterteilung:
**21.06.89 Patentblatt 89/25**

(84) Benannte Vertragsstaaten:
**DE FR GB**

(56) Entgegenhaltungen:
**ELECTRONIC DESIGN, Band 18, Nr. 17, 16. August
1970, Seiten 176,178, Rochelle Park, US; G.
RICHWELL: "IC design makes stable ramp
generator/sawtooth VCO"
ELECTRONIC DESIGN, Band 24, Nr. 23, 8. November
1976, Seite 72, Rochellle Park, US; W.
WOODWARD: "Inexpensive triggered-sweep
generator updates recurring-sweep scopes"**

(73) Patentinhaber: **GRUNDIG E.M.V. Elektro-
Mechanische Versuchsanstalt Max Grundig
holländ. Stiftung & Co. KG., Kurgartenstrasse
37, D-8510 Fürth/Bay. (DE)**

(72) Erfinder: **Zwanzger, Hans, Dipl.- Ing. (FH), Talblick
19a, D-8520 Erlangen (DE)**

## Beschreibung

Die Erfindung bezieht sich auf einen Sägezahngeneratorgemäß den Merkmalen des Oberbegriffs des Patentanspruchs 1.

Sägezahngeneratoren finden bei Oszilloskopen Anwendung, wobei diese entsprechend der Bandbreite der darzustellenden Signale einen weiten Frequenzbereich überstreichen müssen. Bei Oszilloskopen der Niedrigpreisklasse mit z. B. 20 MHz Bandbreite erweisen sich vielfach 18 Zeitbereiche als ausreichend. In Verbindung mit dem Zeit-Fein-Einsteller und einer x 10-Zeitliniendehnung ergibt sich eine Zeitbereichsvariation von $10^7$.

Bei bekannten Oszilloskopen der Niedrigpreisklasse wird die Zeitbereichsumschaltung durch Einschalten verschiedener zeitbestimmender Widerstände und Umschalten verschiedener Lade- oder Integrationskondensatoren erreicht. Zusätzlich wird noch die minimale Wartezeit des Rampengenerators mit umgeschaltet, da verschieden große Zeit-Kondensatoren verschieden lange Entladezeiten benötigen.

Bei hochwertigen Oszilloskopen ist die Verwendung von Miller-Integratoren bekannt, wobei jedoch die auftretenden Restströme den möglichen maximalen Zeitbereich nachteilig beeinflussen. Darüber hinaus sind Schaltungen bekannt, bei denen ein Widerstand an zeitbestimmende Kondensatoren mit hoher Spannung angeschlossen ist und ein Spannungsvergleich durchgeführt wird (einfacher Rampengenerator, an Stromquelle angeschlossen). Auch ist es bekannt, zeitbestimmende Kondensatoren an eine Stromquelle anzuschließen und den Zeit-Fein-Bereich einstellbar zu machen, wobei jedoch bei derartigen Schaltungen die Restströme der Transistoren das Ergebnis verschlechtern.

Ergänzung zur Beschreibungseinleitung v. 13.6.88 Aus "Electronic Design, Band 18, Nr. 17, 16. August 1970, Seiten 176/178" ist ein Sägezahngenerator mit einer Konstantstromquelle bekannt, bei dem die Bereichsumschaltung durch Anlegen von verschiedenen Eingangsspannungen erfolgt. Der bekannte Generator weist einen einzigen zeitbestimmenden Kondensator auf, der von der Konstantstromquelle über einen Widerstand mit einem konstanten Ladestrom beaufschlagt wird.

Aus "Electronic Design, Band 24, Nr. 23, 8. November 1976, Seite 72" ist es ferner bekannt, die Bereichsumschaltung bei einem Sägezahngenerator auch durch Variation der zeitbestimmenden Elemente selbst (Widerstände und Kondensatoren) zu bewerkstelligen.

Der Erfindung leigt die Aufgabe zugrunde, einen Sägezahngenerator für Oszilloskope der unteren Preisklasse zu schaffen, der schaltungstechnisch einfach und preisgünstig ausgebildet ist, nur einen sehr einfachen Zeitbereichsumschalter erfordert und keine Haltezeitumschaltung und keine Abstriche an der Linearität aufweist.

Diese Aufgabe wird erfindungsgemäß mit den im kennzeichnenden Teil des Patentanspruchs 1 angegebenen Merkmalen gelöst.

Weitere Ausgestaltungen der Erfindung sind in den Unteransprüchen beschrieben.

Die mit der Erfindung erzielten Vorteile liegen insbesondere darin, daß nur ein einziger zeitbestimmender Kondensator und ein sehr einfacher Zeitbereichsumschalter vorgesehen sind und keine Wartezeitumschaltung benötigt wird. Darüber hinaus sind am zeitbestimmenden Kondensator keinerlei Transistoren angeschlossen, die nennenswerte Leckströme aufweisen, die das Ergebnis verschlechtern, d. h. zu beträchtlichen Linearitätsfehlern führen würden. Ferner kommt der erfindungsgemäße Sägezahngenerator mit einfachen Schaltungselementen, insbesondere Dioden mit entsprechend geringem Sperrstrom und Operationsverstärkern mit ausreichend geringem Eingangsstrom, aus.

Die Erfindung wird im folgenden unter Bezugnahme auf die Zeichnungsfigur beispielsweise näher erläutert.

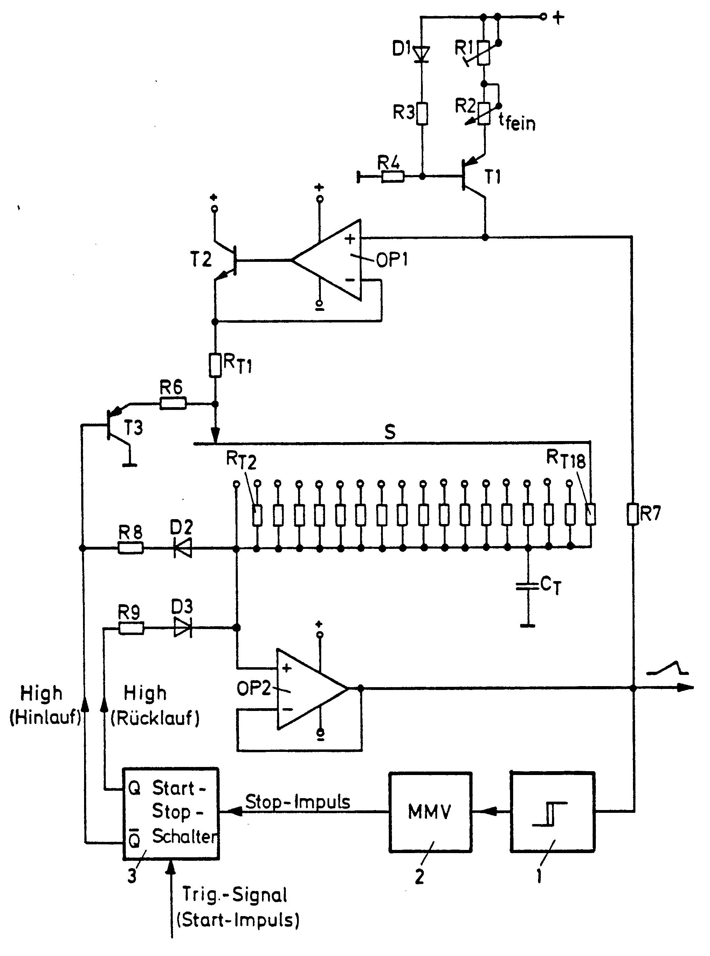

Die Zeichnung zeigt einen erfindungsgemäßen Sägezahngenerator, der bei 18 umschaltbaren Bereichen mit nur einem zeitbestimmenden Kondensator und einem einfachen 18-poligen Bereichsumschalter auskommt.

Gemäß der Zeichnung ist mit dem positiven Spannungspol eine temperaturkompensierte Konstantstromquelle verbunden, die einen Transistor T1, daran angeschlossene einstellbare Widerstände R1 und R2 (für die Zeit-Fein-Einstellung) und mit der Basis verbundene Widerstände R3 und R4 sowie eine Diode D1 aufweist. Der Kollektor des Transistors T1 ist sowohl mit dem nichtinvertierenden Eingang eines ersten Operationsverstärkers OP1 als auch über einen Widerstand R7 mit dem Eingang eines Schmitt-Triggers 1 verbunden. Der invertierende Eingang des Operationsverstärkers OP1 ist an den einen Anschluß eines ersten zeitbestimmenden Widerstandes $R_{T1}$ und den Emitter eines zweiten Transistors T2 angeschlossen, dessen Basis mit dem Ausgang des Operationsverstärkers OP1 und dessen Kollektor mit dem positiven Spannungspol verbunden ist. Der andere Anschluß des ersten zeitbestimmenden Widerstandes $R_{T1}$ ist mit einem Bereichsumschalter S verbunden, der weitere zeitbestimmende Widerstände $R_{T2}$ bis $R_{T18}$ je nach Zeitbereichsumfang (im vorliegenden Beispiel für 18 umschaltbare Bereiche) aufweist. An den miteinander verbundenen Anschlüssen der Widerstände $R_{T2}$ bis $R_{T18}$ ist ein an Masse gelegter zeitbestimmender Kondensator $C_T$ angeschlossen. Die gemeinsamen Anschlüsse der Widerstände $R_{T2}$ bis $R_{T18}$ sind darüber hinaus mit der Anode einer Diode D2 und der Kathode einer Diode D3 sowie mit dem nichtinvertierenden Eingang eines als Impedanzwandler geschalteten zweiten Operationsverstärkers OP2 verbunden. Der Ausgang des zweiten Operationsverstärkers OP2 ist zum einen rückgekoppelt auf seinen invertierenden Eingang, zum anderen mit dem Verbindungspunkt zwischen dem Widerstand R7 und dem Eingang des Schmitt-Triggers 1 verbunden. Der Schmitt-Trigger 1 ist ausgangsseitig mit einem monostabilen Multivibrator 2 verbunden, der einen Stop-Impuls an einen Start-Stop-Schalter 3 abgibt, dem als Triggersignal ferner ein Start-Impuls zuführbar ist. Der Ausgang Q des Start-Stop-Schalters 3 ist über einen Widerstand R9 mit der Anode der Diode D3 verbunden. Der Ausgang $\bar{Q}$ des Start-Stop-Schalters 3 ist zum einen über einen Widerstand R8 mit der Kathode der Diode D2 und zum anderen mit der Basis eines dritten Transistors T3 verbunden, der kollektorseitig an Masse liegt und emitterseitig über einen Widerstand R6 an die Verbindung zwischen dem ersten zeitbestimmenden Widerstand $R_{T1}$ und Umschalter S angeschlossen ist.

Die Funktion der vorstehend beschriebenen erfindungsgemäßen Schaltung wird nun im folgenden näher erläutert:

Die Konstantstromquelle (T1, R1, R2, R3, R4, D1) erzeugt am Widerstand R7 einen stets gleichbleibenden Spannungsabfall von beispielsweise einem Volt. Unter der Voraussetzung, daß am Ausgang Q des Start-Stop-Schalters 3 Low-Pegel, am Ausgang $\bar{Q}$ High-Pegel anliegt, wird der zeitbestimmende Kondensator $C_T$ mit dem Konstantstrom $\frac{1V}{R_T}$ aufgeladen. Der als Impedanzwandler geschaltete Operationsverstärker OP2 greift den linearen Spannungsanstieg am zeitbestimmenden Kondensator $C_T$ ab und führt ihn wegen des Widerstandes R7 um 1 Volt erhöht an den ersten Operationsverstärker OP1, der zusammen mit dem zweiten Transistor T2 für weiterhin konstanten Ladestrom für den zeitbestimmenden Kondensator $C_T$ sorgt. Bei Erreichen des Maximalwertes schaltet der Schmitt-Trigger 1 durch. Der monostabile Multivibrator 2 erzeugt während der Entlade-(Warte-)Zeit den Stop-Impuls für den Start-Stop-Schalter 3, wonach der Ausgang Q des Start-Stop-Schalters 3 auf "HIGH" und der Ausgang $\bar{Q}$ auf "LOW" geht.

Der zeitbestimmende Kondensator $C_T$ wird über die Diode D2 und in den schnellen Zeitbereichen auch noch über den Widerstand R6 und den Transistor T3 entladen.

Das "HIGH"-Signal am Ausgang Q des Start-Stop-Schalters 3 und der über den Widerstand R9 und die Diode D3 dabei fließende Strom spannt die Diode D2 so vor, daß auch bei langer Wartezeit der zeitbestimmende Kondensator $C_T$ stets auf ca 0,6 Volt aufgeladen bleibt.

Nach dem Ende des Stop-Impulses kann ein eintreffender Triggerimpuls (Start-Impuls) am Start-Stop-Schalter 3 einen weiteren Ladevorgang am zeitbestimmenden Kondensator $C_T$ auslösen.

Die vorstehend beschriebene Art der Schaltung erlaubt das Laden eines Kondensators mit einem Konstantstrom, ohne daß ein Kollektor eines bipolaren Transistors mit dem Kondensator verbunden wäre. Bei der großen Variationsbreite des Ladestroms von beispielsweise 25 nA ... 10 mA würde der Kollektor-Reststrom eines Transistors bereits zu beträchtlichen Linearitätsfehlern der Ladefunktion und somit zu einer Verschlechterung des Ergebnisses führen. Demgegenüber sind für die erfindungsgemäße Schaltung Dioden mit entsprechend geringem Sperrstrom und Operationsverstärker mit ausreichend geringem Eingangsstrom anwendbar.

Die in der Schaltung vorgesehenen Elemente Transistor T3, Widerstand R6 sowie Diode D3, Widerstand R9 gewährleisten insbesondere bei den sehr langen Zeitbereichen gleichbleibendes Anfangsniveau der Sägezahnfunktion.

Wie die oben beschriebene Schaltung erkennen läßt, kann der zweite Transistor T2 bei bestimmten Anwendungsfällen entfallen, insbesondere je nach Ausführungsform der Bereiche. Auch kann ausgehend von den Merkmalen der vorstehend beschriebenen erfindungsgemäßen Schaltung diese ohne Schwierigkeiten dahingehend abgewandelt werden, daß auch eine Wartezeit-Regelung vorgesehen wird, ohne daß hierauf sonderlich eingegangen werden müßte.

**Patentansprüche**

1. Sägezahngenerator, mit einer Konstantstromquelle (T1, R1, R2, R3, R4, D1), einem aus verschiedenen zeitbestimmenden Widerständen ($R_{T2}$ bis $R_{T18}$) bestehenden Bereichsumschalter (S) und einem zeitbestimmenden Kondensator ($C_T$), dadurch gekennzeichnet, daß ein Widerstand (R7) vorgesehen ist, der die Konstantstromquelle (T1, R1, R2, R3, R4, D1) über einen Schmitt-Trigger (1) mit einem monostabilen Multivibrator (2) verbindet, daß ferner ein erster Operationsverstärker (OP1) vorgesehen ist, der die Konstantstromquelle über einen weiteren Widerstand ($R_{T1}$) mit dem Bereichsumschalter (S) verbindet, und daß schließlich ein als Impedanzwandler geschalteter und mit seinem Ausgang am Schmitt-Trigger (1) liegender zweiter Operationsverstärker (OP2) vorgesehen ist, dessen Eingang einerseits mit dem Umschalter (S) sowie mit dem einzigen zeitbestimmenden Kondensator ($C_T$) und andererseis über jeweils eine aus einem Widerstand (R8, R9) und einer Diode (D2, D3) bestehenden Reihenschaltung mit dem invertierenden bzw. nicht invertierenden Ausgang (Q, $\bar{Q}$) eines durch den monostabilen Multivibrator (2) gesteuerten Start-Stop-Schalters (3) in Verbindung steht.

2. Sägezahngenerator nach Anspruch 1, dadurch gekennzeichnet, daß die im invertierenden Ausgangszweig des Start-Stop-Schalters (3) liegende Diode (D2) in Sperrichtung und die im nicht invertierenden Ausgangszweig des Start-Stop-Schalters liegende Diode (D3) in Flußrichtung geschaltet ist.

3. Sägezahngenerator nach Anspruch 1 oder 2, dadurch gekennzeichnet, daß der Widerstand (R8) vom Innenwiderstand des Start-Stop-Schalters (3) gebildet ist.

4. Sägezahngenerator nach einem der vorhergehenden Ansprüche 1 bis 3, dadurch gekennzeichnet, daß zwischen den ersten Operationsverstärker (OP1) und den dem Bereichsumschalter (S) vorgeschalteten Widerstand (R_{T1}) ein Transistor (T2) geschaltet ist.

5. Sägezahngenerator nach einem der vorhergehenden Ansprüche 1 bis 4, dadurch gekennzeichnet, daß zwischen den invertierenden Ausgang (Q̄) des Start-Stop-Schalters (3) und den dem Bereichsschalter (S) vorgeschalteten Widerstand (R_{T1}) ein weiterer Transistor (T3) und ein Widerstand (R6) geschaltet sind.

## Claims

1. Sawtooth generator, comprising a constant current source (T1, R2, R3, R4, D1), a range switch (S) consisting of various time-determining resistors (R_{T2} to R_{T18}) and a time-determining capacitor (C_T), characterized in that a resistor (R7) is provided which connects the constant current source (T1, R1, R2, R3, R4, D1) via a Schmitt trigger (1) to a monostable multivibrator (2), that furthermore a first operational amplifier (OP1) is provided which connects the constant current source via a further resistor (R_{T1}) to the range switch (S), and that, finally, a second operational amplifier (OP2) is provided, which is connected as impedance transformer, the output of which is connected to the Schmitt trigger (1) and the input of which is connected, on the one hand, to the switch (S) and to the sole time-determining capacitor (C_T) and, on the other hand, via in each case a series circuit consisting of a resistor (R8, R9) and a diode (D2, D3), to the inverting or non-inverting output (Q, Q̄) of a start/stop switch (3) controlled by the monostable multivibrator (2).

2. Sawtooth generator according to Claim 1, characterized in that the diode (D2) located in the inverting output branch of the start/stop switch (3) is connected in the reverse direction and the diode (D3) located in the non-inverting output branch of the start/stop switch is connected in the forward direction.

3. Sawtooth generator according to Claim 1 or 2, characterized in that the resistor (R8) is formed by the internal resistance of the start/stop switch (3).

4. Sawtooth generator according to one of the preceding Claims 1 to 3, characterized in that a transistor (T2) is connected between the first operational amplifier (OP1) and the resistor (R_{T1}) preceding the range switch (S).

5. Sawtooth generator according to one of the preceding Claims 1 to 4, characterized in that a further transistor (T3) and a resistor (R6) are connected between the inverting output (Q̄) of the start/stop switch (3) and the resistor (R_{T1}) preceding the range switch (S).

## Revendications

1. Générateur de dents de scie comportant une source de courant constant (T1, R2, R3, R4, D1), un commutateur de gammes (S) constitué de différentes résistances déterminant la constante de temps (R_{T2} à R_{T18}) ainsi qu'un condensateur déterminant aussi celle-ci (C_T), caractérisé en ce qu'il est prévu une résistance (R7) qui relie la source de courant constant (T1, R1, R2, R3, R4, D1) par une bascule de Schmitt (1), à un multivibrateur (2) monostable, en ce qu'en outre, est prévu un premier amplificateur opérationnel (OP1) qui relie la source de courant constant au commutateur de gamme (S), par une autre résistance (R_{T1}) et en ce qu'est prévu enfin un deuxième amplificateur opérationnel (OP2) servant de transformateur d'adaptation d'impédance et dont la sortie est appliquée à la bascule de Schmitt (1), dont l'entrée est reliée d'une part au commutateur (S) ainsi qu'au seul condensateur déterminant la constante de temps (C_T) et d'autre part à la sortie inversante ou non inversante (Q, Q̄) d'un commutateur "start-stop" (3) commandé par le multivibrateur (2) monostable, par l'intermédiaire d'un montage en série constitué d'une résistance (R8, R9) et d'une diode (D2, D3).

2. Générateur de dents de scie selon la revendication 1, caractérisé en ce que la diode (D2) située dans la branche de sortie inversante du commutateur "start-stop" (3), est montée dans le sens du blocage, et en ce que la diode (D3) située dans la branche de sortie non inversante du commutateur "start-stop", est montée dans le sens de conduction.

3. Générateur de dents de scie selon la revendication 1 ou 2, caractérisé en ce que la résistance (R8) est formée par la résistance intérieure du commutateur "start-stop" (3).

4. Générateur de dents de scie selon l'une des revendications 1 à 3 ci-dessus, caractérisé en ce qu'un transistor (T2) est monté entre le premier amplificateur opérationnel (OP1) et la résistance (R_{T1}) montée en amont du commutateur de gamme (S).

5. Générateur de dents de scie selon l'une des revendications 1 à 4 ci-dessus, caractérisé en ce qu'un autre transistor (T3) et une résistance (R6) sont montés entre la sortie inversante (Q̄) du commutateur "start-stop" (3) et la résistance (R_{T1}) montée en amont du commutateur de gamme (S).